# EUROPÄISCHE PATENTANMELDUNG

(11) **EP 2 887 392 A2**
(43) Veröffentlichungstag der Anmeldung: **24.06.2015**
(21) Anmeldenummer: 14401110.3
(22) Anmeldetag: 02.12.2014
(51) Int. Cl.: H01L 23/373

(54) **Leistungselektronikmodul und Verfahren zur Herstellung eines Leistungselektronikmoduls**

(30) Priorität: 19.12.2013 DE 102013114438
(71) Anmelder: Karlsruher Institut für Technologie, 76131 Karlsruhe (DE)
(72) Erfinder: Meißer, Michael, DE/76137 Karlsruhe (DE); Blank, Thomas, 76187 Karlsruhe (DE)

(57) **Zusammenfassung**

Die vorliegende Erfindung betrifft ein Leistungselektronikmodul und ein Verfahren zur Herstellung eines Leistungselektronikmoduls. Das Leistungselektronikmodul **(1)** weist ein DCB-Substrat **(2)** auf, auf dem zumindest eine Kupferbahn **(3)** als Oberflächenstruktur angeordnet ist. Es sind zumindest ein Leistungselektronikchip **(4)** und zumindest ein Treibermodul **(5)** mit jeweils zumindest zwei zur Oberfläche **(3a)** der Kupferbahn **(3)** weisenden Anschlüssen **(6a, 6b, 13a, 13b)** angeordnet. Erfindungsgemäß wird eine elektrische Verbindung zwischen dem Treibermodul **(5)** und dem Leistungselektronikchip **(4)** mittels zumindest zweier auf der Kupferbahn **(3)** aufgebrachten elektrisch leitenden Dickfilmstrukturen **(8, 8a, 8b)** und zumindest einer auf der Kupferbahn **(3)** aufgebrachten nicht-leitenden Dickfilmschicht **(9)** bereitgestellt.

## Beschreibung

Die Erfindung betrifft ein Leistungselektronikmodul und ein Verfahren zur Herstellung eines Leistungselektronikmoduls.

Aus dem Stand der Technik sind Leistungshalbleitermodule bekannt, die aus einer Grundplatte, einem Direct-Copper-Bond-Substrat, kurz DCB-Substrat, und aufgelöteten Leistungshalbleiterchips aufgebaut sind, die über Bondverbindungsdrähte am DCB-Substrat kontaktiert sind. Diese finden in den Bereichen Automobilbau, insbesondere Elektromobilität, Luftfahrt, Schienenverkehr sowie erneuerbarer Energien, insbesondere Photovoltaik- oder Windkraftinverter Anwendung, wobei hohe Anforderungen an die Module bzgl. Leistungsdichte, Leistungsgewicht, Lebensdauer und Kosteneffizienz gestellt werden. Bisher werden Chips auf Silizium- oder Siliziumkarbidbasis (SiC) durch unterseitige Löt- und oberseitige Aluminiumbond-Verbindungen elektrisch und thermisch zu einem leistungselektronischen Modul verbunden. Die Halbleitermodule werden bevorzugt zur Verwendung bei hohen Leistungsdichten und hohen Schaltgeschwindigkeiten eingesetzt. Der Stand der Technik setzt sich wie folgt beschrieben zusammen:
Die US 20 130 075 932 A1 offenbart ein Leistungshalbleitermodul mit Dickfilmstrukturen auf einem zusätzlichen Substrat, das Leistungshalbleiterchips von einer Oberseite her kontaktiert. Das unterseitige DCB-Substrat ist grob für den Chip vorstrukturiert, wobei das Dickfilmsubstrat einen Gatetreiber zur Ansteuerung der Leistungshalbleiter tragen kann.

Aus US 7 638 872 B2 ist ein Leistungshalbleitermodul bekannt, wobei der Leistungshalbleiterchip über eine metallisierte und strukturierte Folie oberseitig kontaktiert ist. Über eine Bondverbindung kann eine Durchkontaktierung zwischen Folienober- und Unterseite erfolgen. Die Rückseite des Chips ist auf das DCB-Substrat aufgelötet oder -gesintert.

In US 8 493 762 B2 sind Leistungshalbleiterchips beschrieben, die zu einer Modulgrundplatte vertikal angeordnet sind. Als Strom- und Wärmeleiter sind rechteckige Blöcke vorgesehen, zwischen denen die Chips verlötet oder versintert sind. Die Blöcke selbst sind mit der Grundplatte verlötet oder versintert. Die Blöcke können mit Ausfräsungen versehen werden, womit Leiter auf unterschiedliche elektrische Potentiale geführt werden, um die Verbindung zwischen den einzelnen Chips herzustellen.

Die US 8 436 459 B2 zeigt ein Leistungselektronikmodul, das neben horizontal herausgeführten Leistungsanschlüssen zusätzliche Press- oder Federkontakte zum Anschluss einer Steuerelektronik direkt über dem Modul ermöglichen. Es werden kürzere Anschlusswege und eine höhere Leistungsdichte ermöglicht. Die zusätzlichen Kontakte nehmen dabei viel Raum in Anspruch.

Ein weiteres Leistungselektronikmodul ist in US 6 060 795 A offenbart, wobei das Modul eine zweiseitige Kühlung aufweist. Auf einem oberen Substrat, welches ebenso wie ein unteres Substrat gekühlt wird. ist eine Ansteuerelektronik aufgebracht. Der Leistungshalbleiterchip ist auf einem unteren Substrat angeordnet. Die elektrische Verbindung von dem oberen zu dem unteren Substrat erfolgt mittels einer Durchkontaktierung durch die Keramik. Der Chip und die Treiber sind thermisch unzureichend voneinander entkoppelt.

Aus DE 10 2007 050 868 A1 sind Multichip-Spritzgussmodule bekannt, die eine solide Kupfer-Grundplatte als Substrat aufweisen. Leistungselektronikchips werden in herkömmlicher Verbindungstechnik auf der Oberseite der Platte kontaktiert.

Die DE 10 2005 055 761 B4 offenbart gestapelte Leistungshalbleiterchips in einem Spritzgussmodul mit metallischer, strukturierter Grundplatte. Zwischen zwei Chips ist eine leiterplattenähnliche Struktur vorgesehen, die mit entsprechenden Kontakten bestückt ist.

In DE 10 2006 037 118 B3 wird ein Spritzgussmodul beschrieben, das auf eine Kupferplatte aufgebracht ist. Mittels des Spritzgusses sind mehrere Chips in das Modul integriert und eingeschlossen.

K. Weidner, M. Kaspar et al. stellen in "Planar Interconnect Technology for Power Module System Integration", 7th International Conference on Integrated Power Electronics Systems (CIPS) 2012 eine niederinduktive Verbindungstechnologie vor, die für Leistungsmodule mit geringer Spannungsbelastung geeignet ist, wobei ein Leistungshalbleiterchip mit seiner Unterseite auf ein DCB-Substrat montiert und die Oberseite mittels Aluminiumbonds kontaktiert ist.

In "A Novel Hybrid Packaging Structure for High-Temperature SiC Power Modules" Industry Applications, IEEE Transactions 2013 nutzen R. Wang, C. Zheng **et al.** einen Abstandshalter, um auf diesem mit entsprechendem Abstand zum DCB-Substrat leitende und nicht leitende Strukturen zur Kontaktierung der Leistungshalbleiterchips aufzubringen. Die Verbindung zwischen diesen Strukturen und dem Leistungselektronikchip erfolgt über Drahtbonds. "A Novel High-Temperature Planar Package for SiC Multichip Phase-Leg Power Module", Power Electronics, IEEE Transactions 2013, N. Puqi, T.G. Lei **et al.** offenbart ein Schichtsystem aus Polymid-Isolationsschichten und Kupferschichten, die zusammen mittels Silberpaste mit den Oberseitenkontakten der Leistungselektronikchips verbunden werden. Diese Pasten werden ebenfalls für die Sinterung des Chips auf das DCB-Substrat verwendet.

Es ist wünschenswert, den Integrationsgrad von Treibermodulen und weiteren elektronischen Bauteilen gegenüber dem im Stand der Technik beschriebenen Integrationsgrad erheblich zu erhöhen. Weitere Komponenten wie Gatetreiber, Zwischenkreiskondensatoren oder Ausgangsinduktivitäten werden bisher nicht flächendeckend in Module integriert. Wenn eine oder mehrere dieser Systemkomponenten in ein Leistungselektronikmodul integriert ist, bzw. sind, so befindet sich diese Systemkomponente auf einem anderen Schaltungsträger, bspw. einer Keramikplatte mit Metallisierungsstruktur oder auch Substratstruktur oder einer Leiterplatte, als der Leistungshalbleiter. Gateund Sourceanschlüsse der Leistungshalbleiter werden bisher über Bondkontakte auf Steckanschlüsse geführt, die Gatetreiber-Schaltungen zur Ansteuerung der Leistungselektronikchips befinden sich in der Regel außerhalb des Moduls. Sind die Gatetreiber in das Modul eingebaut, sind sie auf einem eigenen Schaltungsträger bspw. einer Keramikleiterplatte angeordnet und damit auch gesondert über Bonddrähte verbunden. Das bedingt, dass Hochspannungs- und Hochstrombereich, der durch bestimmte Strukturen auf dem DCB-Substrat verwirklicht wird, und Niederspannungs- und Niederstrombereich örtlich getrennt sind. Dies führt zu einer hohen Induktivität und folglich zu langsamen Schaltzeiten des gesamten Moduls. Damit können die möglichen Schaltgeschwindigkeiten, wie sie von Siliziumkarbid-Leistungshalbleiterchips prinzipiell geboten werden, nicht ausgeschöpft werden.

Da bisher weitere Schaltungs- und Systemkomponenten nicht auf das DCB-Substrat integriert wurden, führen erhebliche Induktivitätsbeläge durch Anschlussbeine, Bonddrähte etc. zu einer Begrenzung der maximal möglichen Schaltgeschwindigkeiten und zu starken elektromagnetischen Interferenzen, die aufwändig geschirmt werden müssen.

Ausgehend von diesem Stand der Technik liegt der vorliegenden Erfindung die **Aufgabe** zugrunde, die Betriebsfrequenz und damit die Schaltgeschwindigkeiten von Leistungselektronikschaltungen zu erhöhen.

Diese Aufgabe wird durch ein Leistungselektronikmodul mit den Merkmalen des unabhängigen Anspruchs 1 gelöst.

Die weitere Aufgabe ein Leistungselektronikmodul, das eine hohe Leistungsdichte besitzt, elektronisch effizient und dabei kostengünstig herzustellen, wird durch das Verfahren zur Herstellung des Leistungselektronikmoduls mit den Merkmalen des unabhängigen Anspruchs 8 gelöst.

Bevorzugte Ausführungsformen werden durch die Unteransprüche beschrieben.

Eine erfindungsgemäße Ausführungsform eines Leistungselektronikmoduls weist ein DCB-Substrat auf, auf dem eine oder mehrere Kupferbahn(en) als Oberfläche angeordnet ist bzw. sind. Darauf sind ein oder mehrere Leistungselektronikchip(s) und ein oder mehrere Treibermodul(e) mit jeweils zwei oder mehr zur Oberfläche der Kupferbahn weisenden Anschlüssen angeordnet. Erfindungsgemäß wird eine elektrische Verbindung zwischen dem Treibermodul und dem Leistungselektronikchip bondfrei mittels zwei oder mehrerer auf der Kupferbahn aufgebrachten elektrisch leitenden Dickfilmstrukturen und einer oder mehrerer auf der Kupferbahn aufgebrachten nicht-leitenden Dickfilmschicht(en) bereitgestellt.

Das erfindungsgemäße Modul integriert vorteilhaft wesentliche Teile der Gatetreiberschaltung, insbesondere die Gatetreiberschleife auf einem DCB-Substrat mit Hilfe der Dickschichttechnik. Die parasitäre Schleifeninduktivität kann stark reduziert und höhere Schaltgeschwindigkeiten können ermöglicht werden. Die Integration weiterer Bauteile, wie einem Zwischenkreiskondensator oder einer Ausgangsinduktivität, bzw. weiteren Steuerungs- und/oder Überwachungsschaltungen kann darüber hinaus die Induktivität weiter verringern und noch höhere Schaltgeschwindigkeiten ermöglichen. Die Erfindung ermöglicht die Anordnung von Leistungshalbleiterchips und weiteren Systemkomponenten auf einem einzigen Schaltungsträger. Dies kann durch Aufbringung von Dickfilmstrukturen auf die bereits strukturierte Metalllage des Schaltungsträgers (vorzugsweise DCB / AMB-Substraten), und durch eine Wende-Montage (flip-chip) des oder der Leistungshalbleiter auf den Dickschichtstrukturen oder den Substratstrukturen erreicht werden. Ferner erfolgt dies durch die Verbindung von einem oder mehreren Kontakten des Leistungshalbleiterchips und zusätzlicher Systemkomponenten (vorzugsweise Gatetreiberchip, Zwischekreiskondensator, Ausgangsinduktivität) durch die Dickfilmstrukturen oder auch vorliegenden Substratstrukturen.

Die Verbindung zwischen Chip und Dickfilmstrukturen kann durch Löt-, Kleb- , Ball-bond- oder Sinterprozesse erfolgen. Erfindungsgemäß ist es auch möglich anstatt eines DCB-Substrates ein gleichwertiges AMB- (active metal braze) oder IMS- (insulated metall substrate) zu verwenden. Je nach Anwendung kann das am besten geeignete Substrat Verwendung finden.

Ein Treibermodul kann dabei ein hermetisch geschlossenes oder ein offenes Treibermodul sein.

Die Erfindung sieht bevorzugt vor, dass zwischen den Anschlüssen des Leistungselektronikchips und des Treibermoduls jeweils zwei oder mehr elektrische Verbindungen vorgesehen sein können. Dabei kann eine dieser elektrischen Verbindungen durch die, im Vergleich zu Dünnschichtkontaktierungen verhältnismäßig dicke, Kupferbahn des DCB-Substrates und eine weitere elektrische Verbindung durch eine oder mehrere elektrisch leitende Dickfilmstruktur(en) gebildet werden. Erfindungsgemäß können die elektrischen Verbindungen gegeneinander durch die elektrisch nicht-leitende Dickfilmschicht isoliert sein, die mit der elektrisch leitenden Dickfilmstruktur eine Schichtanordnung auf der Oberfläche der Kupferbahn bildet. Hierdurch kann eine Verringerung des Bauvolumens und auch des Gesamtgewichts des Leistungselektronikmoduls erreicht werden. Dies begünstigt eine Erhöhung der Leistungsdichte und ermöglich höhere Betriebsfrequenzen aufgrund der durch die verringerte parasitäre Induktivität verminderten Schaltverluste. Um die durch die erfindungsgemäße Struktur bereitgestellte Fähigkeit einer hohen Schaltungsgeschwindigkeit auszuschöpfen, können insbesondere Leistungshalbleiter aus Siliziumkarbid eingesetzt werden.

Erfindungsgemäß kann vorgesehen sein, dass der Leistungselektronikchip mit einer Oberseite, die sogenannte Kopfseite, auf der Oberfläche der Kupferbahn angeordnet ist. Die Kopfseite ist in der üblichen Kontaktierung mit einer Aluminiumbeschichtung versehen und wird über Aluminiumbonddrähte kontaktiert. Die Wendemontierung des Chips oder auch sogenannte "Flip-Chip"-Technik ermöglicht eine Kontaktierung der Oberseite des Leistungselektronikchips mit den Leiterbahnstrukturen auf dem Substrat. Die Gatetreiberschaltung kann hierdurch niederinduktiv angeschlossen werden und die Schaltgeschwindigkeit, ohne parasitäre Resonanzen hervorzurufen, erhöht werden.

Die Erfindung kann in einer weiteren Ausführungsform vorsehen, dass der Leistungselektronikchip eine Metalllage oder Kontaktierungsbügel als Source und eine weitere Metalllage oder Kontaktierungshügel als Drain aufweist. Es sind unterschiedliche Kontaktierungsmöglichkeiten gegeben, die je nach verwendetem Leistungselektronikchip eingesetzt werden können. Bevorzugt kann der Leistungselektronikchip dabei ein Leistungshalbleiterchip sein, der für hohe Betriebsfrequenzen ausgelegt ist. Dabei kann vorgesehen sein, dass ein erster Anschluss ein Source-Anschluss, ein zweiter Anschluss ein Gate auf der dem DCB-Substrat zugewandten Seite des Leistungselektronikchips und ein dritter Anschluss in Drain-Anschluss auf der dem DCB-Substrat abgewandten Seite ist.

Bevorzugt kann der Leistungselektronikchip sowohl auf der dem DCB-Substrat zugewandten Seite (Source und Gateanschluss) wie auch der dem DCB-Substrat abgewandten Seite (Drain) Metallisierungsflächen aufweisen, die vorteilhaft mit einer oder mehreren Kupfer- oder Silberschicht(en) beschichtet sind, so dass sie gelötet oder gesintert werden können. Ferner kann der Leistungselektronikchip auch mit Ball-bonds oder Stud-bumps, d. h. Kontaktierungshügeln, bspw. aus Aluminium oder Gold, versehen sein, die wiederum durch Lötung, Sinterung oder Klebung entweder mit einer leitenden Dickfilmstruktur oder einer Kupferleiterbahn auf dem DCB-Substrat verbunden sind.

In einer Weiterbildung der Erfindung können ein erster Anschluss als Source des Leistungshalbleiterchips mit einer ersten Dickfilmstruktur und ein zweiter Anschluss als Gate des Leistungshalbleiterchips mit einer zweiten Dickfilmstruktur elektrisch verbunden sein. Erfindungsgemäß kann die erste Dickfilmstruktur mit der nicht-leitenden Dickfilmschicht die Schichtanordnung bilden. Es können, je nach verwendeten Komponenten, verschiedene Strukturierungen verwendet werden, wobei das Substrat so mit den Dickfilmstrukturen bedeckt werden kann, so dass eine Kontaktierung der Komponenten Leistungselektronikmodul und Treibermodul einfach und schnell erfolgen kann. Die Kontaktierung mittels Dickfilmschichten reduziert zudem den thermischen Widerstand sowohl des Leistungselektronikchips, als auch weiterer Bauelemente in Richtung eines Kühlkörpers. Wärme entsteht vor allem unter der Aluminiumschicht auf der Kopfseite der Leistungselektronikchips. Durch die erfindungsgemäße Wende-montage liegt diese Wärmequelle näher am Substrat und der thermische Weg zum Kühlkörper ist kürzer. Dadurch ist der Temperaturgradient über dem Schichtaufbau Chip-DCB geringer, wodurch bei gleicher Verlustleistung im Chip und gleicher Kühlkörpertemperatur die Temperatur des Chips effektiv gesenkt werden kann.

Für eine optimale Wärmeabgabe und damit thermische Stabilität der Bauteile auf dem DCB-Substrat kann die Erfindung vorsehen, dass ein Metallblock, bevorzugt ein Kupferblock angeordnet ist, der in thermischem Kontakt mit dem Leistungselektronikchip steht. Der Metallblock kann in räumlicher Nähe zu oder direkt auf dem Bauteil angeordnet sein. Durch Aufbringen bspw. durch Auflöten oder -kleben einer solchen größeren Wärmekapazität, kann Wärme, die bei kurzzeitigen Spitzenbelastungen des Halbleiters auftritt, gepuffert werden. Die Pulsbelastbarkeit des entsprechenden Bauteils wird erhöht und durch thermische Zyklen hervorgerufener mechanischer Stress reduziert.

Die Dickfilmstrukturen können aus verschiedenen Materialien, die dem Zweck nach geeignet sind, aufgebaut werden. Erfindungsgemäß kann die leitende Dickfilmstruktur Metall, bevorzugt ein Edelmetall, wie Gold oder Silber aufweisen. Daneben kann die nicht-leitende Dickfilmschicht Keramik, Glas oder organisches Material aufweisen. Die vorgenannten Materialien lassen sich auch in der bekannten Weise zuverlässig als Dickfilme auf das Substrat aufbringen, ohne dass Unterbrechungen oder Kurzschlüsse auftreten können.

Ferner kann vorgesehen sein, dass das DCB-Substrat neben der Kupferbahn eine oder mehrere Keramiklage(n) aus Aluminiumnitrid, Aluminiumoxid oder Siliziumnitrid und eine oder mehrere unterseitige Metalllage(n), bevorzugt aus Kupfer, aufweist. Die Verwendung eines DCB-Substrates, d. h. eines Direct-Copper-Bond-Substrates ermöglicht ferner eine sehr einfache Kontaktierung der einzelnen Komponenten und ist günstig herzustellen.

Auch kann das DCB-Substrat für eine verbesserte Stabilität auf einer Grundplatte, die bspw. aus Kupfer oder einer Keramik besteht, angeordnet sein.

Das erfindungsgemäße Verfahren zur Herstellung des Leistungselektronikmoduls umfasst die folgenden Schritte:
- Bereitstellen des DCB-Substrates und Strukturieren des Substrats mit einer oder mehreren Kupferbahn(en),
- Aufbringen der Dickfilmstruktur(en) und der nicht-leitenden Dickfilmschicht
   zum Aufbau der Schichtanordnung,
- Anordnen des Leistungselektronikchips und des Treibermoduls auf der Oberfläche der Kupferbahn, und
- elektrisches und thermisches Verbinden des Leistungselektronikchips und des Treibermoduls mit der Kupferbahn.

Vorteilhaft können dadurch die genannten Komponenten Leistungselektronikchip und Treibermodul mit den Leiterstrukturen auf dem Substrat verbunden werden. Das elektrische Verbinden kann durch Sinter-, Löt-, Klebeoder Bondtechniken erfolgen. Es kann auch vorgesehen sein, dass in einem Schritt nur einzelne Komponenten auf dem DCB-Substrat angeordnet und kontaktiert werden. Das DCB-Substrat kann bspw. mittels Ätzen vorstrukturiert werden.

Das Verfahren kann erfindungsgemäß vorsehen, dass die Dickfilmstrukturen oder auch die nicht-leitende Dickfilmschicht auf dem DCB-Substrat mittels einer Paste aufgebracht werden. Die Dickfilmstruktur oder auch die nicht-leitende Dickfilmschicht können erfindungsgemäß in einem Bereich von 20 µm bis zu 500 µm, bevorzugt 100 µm dick sein. Die Dickfilme sind leicht aufzubringen, wobei neben einem Pastenauftrag auch andere bekannte Verfahren wie Sputtern etc. verwendet werden können. Das DCB-Substrat kann somit um zusätzliche Lagen aus Dickfilmschichten erweitert werden, wodurch eine subtraktive Strukturierung der Kupfer-Metallisierung des DCBs, wie sie für eine Gestaltung von Niederspannungskreisen bisher notwendig war, vermieden werden kann. Zudem sind wesentlich feinere Strukturen möglich, die auch die Kontaktierung von Treibermodulen mit geringem Pin-Abstand erlauben.

Ferner kann vorgesehen sein, dass der Leistungselektronikchip mit einer Kopfseite zur Oberfläche der Kupferbahn weisend auf der Kupferbahn wende-montiert wird. Diese Flip-Chip-Montage ermöglicht eine einfache Kontaktierung gerade bei vielen Einzelkontakten und erlaubt einen niederinduktiven Anschluss der Gatetreiberschaltung, wodurch die Schaltgeschwindigkeit erhöht werden kann, ohne parasitäre Resonanzen in den Schaltkreisen hervorzurufen.

In einer weiteren Ausführungsform sieht das Verfahren vor, dass zur elektrischen Verbindung des Leistungselektronikchips und auch des Treibermoduls eine metallisierte Kontaktierungsschicht, bevorzugt aus Edelmetall, auf einer oder mehrerenKontaktierungsseiten der Komponenten oder Folien, Ball-Bonds oder Kontaktierungshügel, sogenannte "stud-bumps", auf die Kupferbahn gelötet, gebondet oder gesintert werden können. Eine gute elektrische Verbindung kann durch Gold oder Aluminium erreicht werden. Die metallene Kontaktierungsschicht kann bspw. eine Aluminiumlage sein, auf die eine Folie aus Kupfer, Silber oder Gold gebondet ist. Diese Folie kann dann über eine Sinter- oder Lötverbindung mit der DCB-Oberfläche verbunden werden. Eine Verbindung kann auch direkt auf das DCB-Substrat erfolgen, das dazu auch mit einem Gold-, Kupfer- und/oder Silber-Finish versehen sein kann. Auch andere Bauteile können auf diese Weise mit dem DCB-Substrat kontaktiert werden.

Ferner kann die Erfindung vorsehen, dass der dritte Anschluss also der Drain-Anschluss des Leistungselektronikchips mit der Kupferbahn mittels Aluminium-Bonddraht oder Kupferband elektrisch verbunden werden kann. Diese Art der Verbindung ist einfach und schnell herzustellen.

In einer Weiterbildung der Erfindung können ein oder mehrere weitere elektronische Bauteile, bevorzugt bspw. ein keramischer Zwischenkreiskondensator, auf dem DCB-Substrat angeordnet und elektrisch kontaktiert werden. Die zusätzliche Integration bspw. eines Zwischenkreiskondensators und einer Ausgangsinduktivität kann darüber hinaus die parasitäre Induktivität des Leistungskreises und die elektromagnetische Abstrahlung verringern. Diese Integration kann auch auf der Schichtanordnung erfolgen, wobei die elektronischen Bauteile liegend oder stehend beispielhaft mittels Drahtbonds oder einer Kupferbandlötung verbunden werden können.

Das vorgenannte Herstellungsverfahren ermöglicht das Erstellen eines Moduls mit minimaler Eingangsinduktivität sowie sehr guter thermischer Anbindung des Treibermoduls.

Weitere Ausführungsformen, sowie einige der Vorteile, die mit diesen und weiteren Ausführungsformen verbunden sind, werden durch die nachfolgende ausführliche Beschreibung deutlich und besser verständlich. Unterstützend hierbei ist auch der Bezug auf die Figur in der Beschreibung. Es zeigt
- **Fig. 1**: eine schematische Seitenansicht eines erfindungsgemäßen Leistungselektronikmoduls, und
- **Fig. 2**: eine schematische Seitenansicht des erfindungsgemäßen Leistungselektronikmoduls mit einem weiteren integrierten Bauteil.

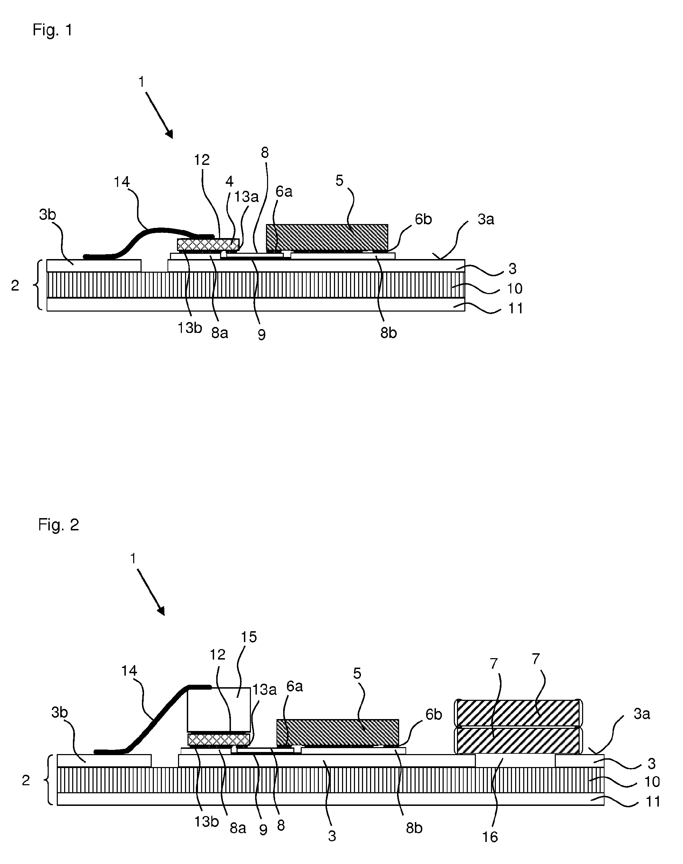

**Fig. 1** zeigt ein Leistungselektronikmodul **1.** Ein DCB-Substrat **2** bildet die Grundlage und ist im Wesentlichen aus drei Schichten, einer thermisch leitenden und elektrisch isolierenden Keramiklage **10,** einer unteren Metalllage **11** sowie einer auf die Keramiklage **10** strukturierten oberen Kupferbahn **3** aufgebaut. Die Kupferbahn **3** hat unterschiedliche Bereiche, die Kontakte für einzelne Bauteile auf dem Substrat **2** oder Zugänge für eine Stromversorgung bilden.

Auf einer Oberseite **3a** der Kupferbahn **3** sind ferner verschiedene Dickfilmschichten **8, 8a, 8b, 9** aufgebracht, auf denen selbst wiederum elektronische Bauteile angeordnet und darüber mit der Kupferbahn **3** elektrisch kontaktiert sind. Die elektronischen Bauteile sind ein Leistungselektronikchip **4** und ein Treibermodul **5** zur Steuerung des Leistungselektronikchips 4. Die elektrische Verbindung der Komponenten untereinander kann dabei durch Löten, Sintern oder auch Kleben mittels einer elektrisch leitenden Paste erfolgen.

Der Leistungselektronikchip **4** ist "flip-chip", d. h. gewendet, mit seiner Kopfseite auf der Oberfläche der Dickfilmstruktur **8a** montiert, so dass eine Unterseite nach oben weist. Die Unterseite des Leistungselektronikchips **4** ist die Source und weist eine Metalllage als Drain **12** auf, die zur Kontaktierung des Chips **4** mit der Kupferbahn **3b** in der linken Bildhälfte dient. Zur Kontaktierung ist ein Kupferband als Metallband **14** mit dem Drain 12 des Leistungselektronikchips **4** und der Kupferbahn 3b elektrisch verbunden. Die Kupferbahn **3b** ist ferner mit einer Strom- bzw. Spannungsquelle verbunden.

An seiner Kopfseite, die zum DCB-Substrat **2** zeigt, hat der Leistungselektronikchip **4** Metallisierungen als ersten Anschluss **13a** (Gate-Anschluss) und zweiten Anschluss 13b (Source-Anschluss) des Chips **4** bilden.

Um das Leistungselektronikmodul **4** und das Treibermodul **5,** wie in **Fig. 1** gezeigt, gemeinsam auf dem Substrat **2** anzuordnen und zu kontaktieren, sind auf der Kupferbahn **3** im Wesentlichen drei leitende Dickfilmstrukturen **8, 8a, 8b** aufgebracht. Eine zweite Dickfilmstruktur **8a** ist unterhalb des Leistungselektronikmoduls **4** angeordnet und mit dem zweiten Anschluss **13b** kontaktiert, wohingegen eine dritte Dickfilmstruktur **8b** zwischen Kupferbahn **3** und Treibermodul **5** liegt. Zwischen der ersten Dickfilmstruktur **8a** und der zweiten Dickfilmstruktur **8b** ist auf der Kupferbahn **3** liegend eine nicht-leitende Dickfilmschicht **9** aufgebracht. Diese trägt die erste Dickfilmstruktur **8** und isoliert sie elektrisch von der Kupferbahn **3.** Mit der ersten Dickfilmstruktur **8** ist der erste Anschluss **13a** des Leistungselektronikchips **4** sowie ein erster Anschluss 6a des Treibermoduls **5** elektrisch verbunden. Ein zweiter Anschluss **6b** des Treibermoduls **5** ist mit der dritten Dickfilmstruktur **8b** elektrisch verbunden. Das Treibermodul **5** und der Leistungselektronikchip **4** sind damit elektrisch kontaktiert und thermisch sehr gut an das DCB-Substrat **2** gekoppelt.

**Fig. 2** zeigt das Leistungselektronikmodul **1** aus **Fig. 1** mit weiteren Bauteilen. In der rechten Bildhälfte sind zwei gehäuste Zwischenkreiskondensatoren **7** übereinander auf der Kupferbahn **3** angeordnet. Die Kupferbahn **3** weist eine Isolierungslücke **16** auf, wodurch die elektrischen Kontakte der Kondensatoren **7** nicht kurzgeschlossen sind. Die Isolierungslücke **16** ist einer Größenordnung der verwendeten Bauteile angepasst, so dass die Kondensatoren **7** zur Kontaktierung einfach angeordnet werden können, ohne Kurzschlüsse zu erzeugen. Die Kupferbahnen **3,** bzw. **3a** verbinden den Zwischenkreiskondensator **7** mit Anschlüssen des Leistungshalbleiters **4.** Neben dem Zwischenkreiskondensator **7** können auch weitere Kondensatoren und andere oberflächenmontierbare Bauelemente auf die Dickfilmstrukturen aufgebracht werden. Somit können Kondensatoren auch mit dem Gatetreiberschaltkreis **5** verbunden werden und damit bspw. zur Glättung der Versorgungsspannung der Gatetreibers **5** beitragen.

Ferner ist zur besseren Wärmepufferung ein Materialblock **15,** vorzugsweise aus Kupfer als thermisches Speicherelement auf dem Leistungselektronikchip **4** angeordnet. Zur elektrischen und thermischen Verbindung ist der Materialblock **15** mit dem Drain **12** versintert oder verlötet. Das Metallband **14,** vorzugsweise aus Kupfer, ist dabei mit einer Oberseite des Materialblocks **15** und somit auch mit dem Drain **12** und dem Leistungselektronikchip **4** elektrisch verbunden. Statt eines Metallbandes **14** können auch Drahtbonds verwendet werden. Das Metallband **14** kann auch zwischen der Oberseite des Leistungselektronikchips **4** und dem Materialblock **15** angeordnet sein.

**BEZUGSZEICHENLISTE**

| | |
|---|---|
| 1 | Leistungselektronikmodul |
| 2 | DCB-Substrat |
| 3 | Kupferbahn |
| 3a | Oberfläche der Kupferbahn |
| 4 | Leistungselektronikchip |
| 5 | Treibermodul |
| 6a | Erster Anschluss Treibermodul |
| 6b | Zweiter Anschluss Treibermodul |
| 7 | Zwischenkreiskondensator |
| 8 | Erste leitende Dickfilmstruktur |
| 8a | Zweite leitende Dickfilmstruktur |
| 8b | Dritte leitende Dickfilmstruktur |
| 9 | Nicht-leitende Dickfilmschicht |
| 10 | Keramiklage des DCB-Substrates |
| 11 | Untere Metalllage des DCB-Substrates |
| 12 | Metallisierung des Leistungshalbleiterchips (Drain) |
| 13a | Erster Anschluss Leistungselektronikchip (Gate) |
| 13b | Zweiter Anschluss Leistungselektronikchip (Source) |
| 14 | Metallband |
| 15 | Materialblock |
| 16 | Isolierungslücke |

## Patentansprüche

1. Leistungselektronikmodul **(1),** das ein Substrat **(2)** aufweist, auf dem zumindest eine Kupferbahn **(3)** als Oberflächenstruktur angeordnet ist, und wobei zumindest ein Leistungselektronikchip **(4)** und zumindest ein Treibermodul **(5)** mit jeweils zumindest zwei zur Oberfläche **(3a)** der Kupferbahn **(3)** weisenden Anschlüssen **(6a,6b,13a,13b)** angeordnet sind,
**dadurch gekennzeichnet, dass**
eine elektrische Verbindung zwischen dem Treibermodul **(5)** und dem Leistungselektronikchip **(4)** mittels zumindest zweier auf der Kupferbahn **(3)** aufgebrachten elektrisch leitenden Dickfilmstrukturen **(8,8a,8b)** und zumindest einer auf der Kupferbahn **(3)** aufgebrachten nicht-leitenden Dickfilmschicht **(9)** bereitgestellt wird.

2. Leistungselektronikmodul **(1)** nach Anspruch 1,
**dadurch gekennzeichnet, dass**
- jeweils zumindest zwei elektrische Verbindungen zwischen den Anschlüssen **(6a,6b,13a,13b)** des zumindest einen Leistungselektronikchips **(4)** und des zumindest einen Treibermoduls **(5)** vorgesehen sind, und
- zumindest eine elektrische Verbindung durch die Kupferbahn **(3)** und zumindest eine weitere elektrische Verbindung durch zumindest eine elektrisch leitende Dickfilmstruktur **(8,8a,8b)** gebildet wird, und
- die elektrischen Verbindungen gegeneinander durch zumindest eine elektrisch nicht-leitende Dickfilmschicht **(9)** isoliert sind, die mit der zumindest einen elektrisch leitenden Dickfilmstruktur **(8,8a,8b)** eine Schichtanordnung auf der Oberfläche **(3a)** der Kupferbahn **(3)** bildet.

3. Leistungselektronikmodul **(1)** nach Anspruch 1 oder 2,
**dadurch gekennzeichnet, dass**
eine Kopfseite des Leistungselektronikchips **(4)** elektrisch leitend mit der Oberfläche **(3a)** der Kupferbahn **(3)** kontaktiert ist.

4. Leistungselektronikmodul **(1)** nach zumindest einem der Ansprüche 1 bis 3,
**dadurch gekennzeichnet, dass**
der Leistungselektronikchip **(4)** mindestens drei Anschlüsse aufweist, wobei ein erster Anschluss **(13b)** ein Source-Anschluss, ein zweiter Anschluss ein Gate **(13a)** auf der dem DCB-Substrat **(2)** zugewandten Seite des Leistungselektronikchips **(4)** und ein dritter Anschluss **(12)** ein Drain-Anschluss auf der dem DCB-Substrat **(2)** abgewandten Seite ist.

5. Leistungselektronikmodul **(1)** nach Anspruch 4,
**dadurch gekennzeichnet, dass**
ein erster Anschluss **(13a)** als Source des Leistungshalbleiterchips **(4)** mit einer ersten Dickfilmstruktur **(8)** und ein zweiter Anschluss **(13b)** als Gate des Leistungshalbleiterchips **(4)** mit einer zweiten Dickfilmstruktur **(8a)** elektrisch verbunden ist.

6. Leistungselektronikmodul **(1)** nach zumindest einem der Ansprüche 1 bis 5,
**dadurch gekennzeichnet, dass**
- die leitende Dickfilmstruktur **(8)** Metall, bevorzugt ein Edelmetall, aufweist und/oder
- die nicht-leitende Dickfilmsschicht **(9)** eine Keramik, ein Glas oder ein organisches Material aufweist.

7. Leistungselektronikmodul **(1)** nach zumindest einem der Ansprüche 1 bis 6,
**dadurch gekennzeichnet, dass**
das DCB-Substrat **(2)** neben der zumindest einen Kupferbahn **(3)** zumindest eine Keramiklage **(10)** aus Aluminiumnitrid, Aluminiumoxid oder Siliziumnitrid und zumindest eine unterseitige Metalllage **(11),** bevorzugt aus Kupfer, aufweist.

8. Verfahren zur Herstellung des Leistungselektronikmoduls **(1)** nach einem der Ansprüche 1 bis 7,
**umfassend die Schritte**
- Bereitstellen des DCB-Substrates **(2)** und Strukturieren des Substrats **(2)** mit zumindest einer Kupferbahn **(3),**
- Aufbringen der zumindest einen Dickfilmstruktur **(8,8a,8b)** und der zumindest einen nicht-leitenden Dickfilmschicht **(9)** zum Aufbau der Schichtanordnung,
- Anordnen des Leistungselektronikchips **(4)** und/oder des Treibermoduls **(5)** auf der Oberfläche **(3a)** der Kupferbahn **(3),** und
- elektrisches und thermisches Verbinden des Leistungselektronikchips **(4)** und/oder des Treibermoduls **(5)** mit der Kupferbahn **(3).**

9. Verfahren nach Anspruch 8,
**umfassend den Schritt**
Aufbringen der Dickfilmstruktur **(8, 8a, 8b)** und/oder der nicht-leitenden Dickfilmschicht **(9)** auf dem DCB-Substrat mittels einer Paste, wobei die Dickfilmstruktur **(8,8a,8b)** und/oder die nicht-leitende Dickfilmschicht **(9)** eine Schichtdicke im Bereich von 20 µm bis zu 500 µm, bevorzugt 100 µm aufweist.

10. Verfahren nach Anspruch 8 oder 9,
**wobei**
der Leistungselektronikchip **(4)** mit seiner Kopfseite zur Oberfläche **(3a)** der Kupferbahn **(3)** weisend auf der Kupferbahn **(3)** wende-montiert wird.

11. Verfahren nach zumindest einem der Ansprüche 8 bis 10,
**umfassend den Schritt**
zur elektrischen Verbindung des Leistungselektronikchips **(4)** und/oder des Treibermoduls **(5)** Löten, Bonden oder Sintern einer metallisierten Kontaktierungsschicht, bevorzugt aus Edelmetall, oder von Folien, Ballbonds oder von Kontaktierungshügeln auf die Kupferbahn **(3).**

12. Verfahren nach zumindest einem der Ansprüche 8 bis 11,
**umfassend den Schritt**
elektrisches Verbinden des dritten Anschlusses **(12)** des Leistungselektronikchips **(4)** mit der Kupferbahn **(3b)** mittels gebondetem Aluminium- oder Kupfer-Bonddraht oder Aluminium- oder Kupfer-Bondband **(14).**
